# EUROPEAN PATENT SPECIFICATION

(11) **EP 2 577 873 B1**
(45) Date of publication and mention of the grant of the patent: **09.03.2016**
(21) Application number: 11727018.1
(22) Date of filing: 01.06.2011
(51) Int. Cl.: G06F 17/30, H03M 7/30

(54) **A METHOD AND SYSTEM FOR COMPRESSING XML DOCUMENTS**
VERFAHREN UND SYSTEM ZUR KOMPRIMIERUNG VON XML-DOKUMENTEN
PROCÉDÉ ET SYSTÈME DE COMPRESSION DE DOCUMENTS XML

(30) Priority: 01.06.2010 US 791337
(43) Date of publication of application: 10.04.2013
(73) Proprietor: Oracle International Corporation, Redwood Shores, CA 94065 (US)
(72) Inventor: CHANDRASEKAR, Sivasankaran, Menlo Park California 94025 (US); AGARWAL, Nipun, Santa Clara California 95054 (US)
(74) Representative: Dendorfer, Claus
(86) International application number: PCT/US2011/038762
(87) International publication number: WO 2011/153241

(56) References cited:
- US-A1- 2009 106 210
- US-A1- 2009 287 737
- US-A1- 2010 278 446
- Daniel J. Abadi: "Query Execution in Column-Oriented Database Systems", , 29 February 2008 (2008-02-29), XP55003471, Retrieved from the Internet: URL:http://cs-www.cs.yale.edu/homes/dna/pa pers/abadiphd.pdf [retrieved on 2011-07-25]
- FLORESCU D ET AL: "Storing and querying XML data using an RDBMS", QUARTERLY BULLETIN OF THE COMPUTER SOCIETY OF THE IEEE TECHNICAL COMMITTEE ON DATA ENGINEERING, THE COMMITTEE, WASHINGTON, DC, US, vol. 22, no. 3, 1 September 1999 (1999-09-01), pages 27-34, XP002274305, ISSN: 1053-1238

## Description

### FIELD OF THE INVENTION

The present invention relates to database systems, and in particular, storing XML data in database systems more efficiently.

### BACKGROUND

The approaches described in this section are approaches that could be pursued, but not necessarily approaches that have been previously conceived or pursued. Therefore, unless otherwise indicated, it should not be assumed that any of the approaches described in this section qualify as prior art merely by virtue of their inclusion in this section.

Extensible Markup Language (XML) is a World Wide Web Consortium (W3C) standard for representing data. Many applications are designed to output data in the form of XML documents. XML data comprises structured data items that form a hierarchy. In XML, data items known as elements are delimited by an opening tag and a closing tag. An element may also comprise attributes, which are specified in the opening tag of the element. Text between the tags of an element may represent any sort of data value, such as a string, date, or integer. An element may have one or more children. The resulting hierarchical structure of XML-formatted data is discussed in terms akin to those used to discuss a family tree. For example, a sub-element is said to descend from its parent element or any element from which its parent descended. A parent element is said to be an ancestor element of any sub-element of itself or of one of its descendant elements. Collectively, an element along with its attributes and descendants, are referred to as a tree or a sub-tree.

With the rise and popularity of XML, many relational database systems have added support for storing, managing and querying XML content. The term relational database system refers to any database system that supports the relational model of data processing, including database systems that may support other models of data processing, such as object-relational and various models the XML standard (e.g. XQuery, XPath)

Relational database systems that store XML documents may store individual elements in separate rows of a table. Such documents are referred to herein as shredded documents. The process of dividing an XML document into discrete element values (or representations thereof) for storage in the rows that hold the data representing the XML document and/or nodes thereof is referred to as shredding the XML document.

An XML document may be fully shredded into object-relational storage, partially shredded, or stored in LOB storage and referenced by an XML index. If fully shredded, the XML document can be fully reconstructed from the data stored relationally in the database. If partially shredded, in hybrid form, the document is stored in LOB storage with at least a portion of the document stored in an object-relational form, such as in an XML index. Although the portion stored in the XML index may not represent the entire document, the XML index may be used to efficiently access those portions of the document that are indexed. Certain fields from the XML document may be indexed, while other fields from the XML document may be ignored during indexing.

When an XML document is shredded and stored at least partially in object-relational form, values from the XML document may be stored in different rows in same or different columns, or in different columns in same or different rows. The values stored object-relationally may include values for certain fields of the document selected for indexing, and may exclude values for other fields of the document not selected for indexing. In one example, several values for a given field in the document are stored in different columns in the same row in the index. In another example, several values for a given field in the document are stored in different rows in the same column in the index.

A shredded version of a XML document may have much a larger storage footprint than that of the XML documents stored in other forms, such as text based file storage. There is a thus a need to store shredded XML documents more efficiently.

### DATABASES AND DATABASE SERVERS

Generally, a server, such as a database server, is a combination of integrated software components and an allocation of computational resources, such as memory, a node, and processes on the node for executing the integrated software components, where the combination of the software and computational resources are dedicated to providing a particular type of function on behalf of clients of the server. A database server governs and facilitates access to a particular database, processing requests by clients to access the database.

A database comprises data and metadata that is stored on a persistent memory mechanism, such as a set of hard disks. Such data and metadata may be stored in a database logically, for example, according to relational and/or object-relational database constructs. Database metadata defines database objects, such as tables, object tables, views, or complex types, such as object types, and, importantly table functions. SQL data definition language ("DDL") instructions are issued to a database server to create or configure database objects.

Generally, data is logically arranged within a database as one or more data containers. Each container contains records, and the data within each record is organized into one or more fields. In relational database systems, the data containers are typically referred to as tables, the records are referred to as rows, and the fields are referred to as columns. In object oriented databases, the data containers are typically referred to as object types or classes, the records are referred to as objects, and the fields are referred to as attributes. Other database architectures may use other terminology. Systems that implement the present invention are not limited to any particular type of data container or database architecture. However, for the purpose of explanation, the examples and the terminology used herein shall be that typically associated with relational or object-relational databases. Thus, the terms "table", "row" and "column" shall be used herein to refer respectively to the data container, record, and field.

### DATA BLOCKS

While databases are arranged logically in data containers, those containers are themselves typically stored in one or more data blocks on, for example, a hard disk. So, for example, while most users will issue instructions or queries to the database server that refer to data via reference to tables, rows, and columns, that data is actually stored in a database as a collection of data blocks. Through the use of various stored metadata, indexes, and headers, the database server is able to interpret the data within these data blocks as logical tables, rows, and columns.

A data block is an atomic unit of storage space allocated to store raw data for one or more database records (e.g., rows), or portions thereof. Typically, a database system is configured to read and write database records from persistent storage and volatile memory in units no smaller than data blocks. When a record from a data block needs to be retrieved, the entire data block is read into an in-memory buffer the database system uses to temporarily store data blocks. In many databases, data blocks are all of a common size. Database administrators select this size based on a number of considerations. However, tables often comprise more data than can fit in a single data block. Thus, tables often span many data blocks.

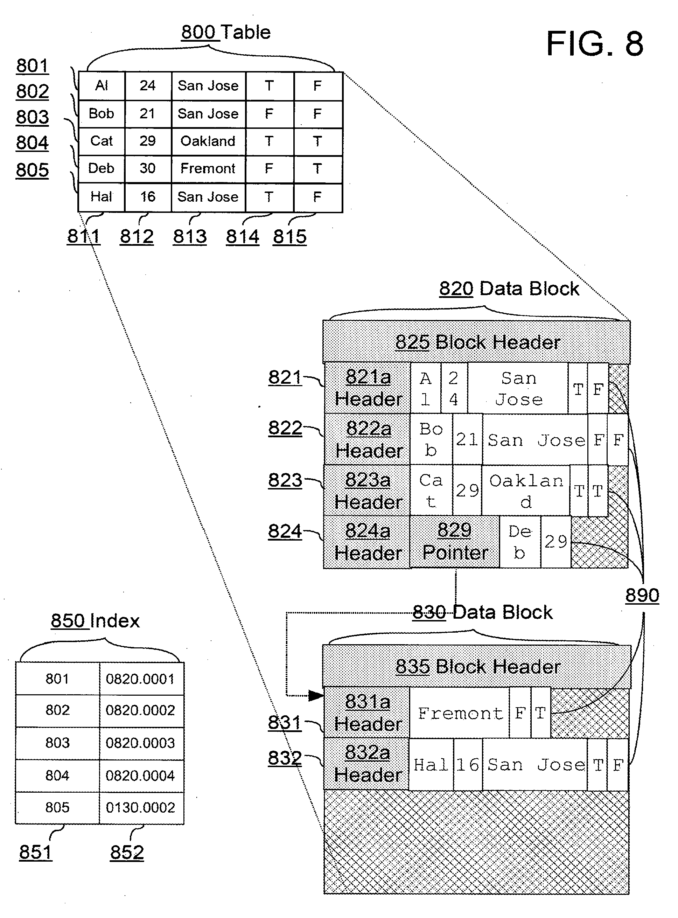

For example, FIG. 8 illustrates how a table 800 may be stored in example data blocks 820 and 830. Because data blocks 820 and 830 are both of a predefined size that is smaller than table 800, it is impossible to fit table 800 in a single data block. Thus table 800 is stored in two data blocks.

Data blocks are typically subdivided into one or more contiguous segments herein described as "data block rows." When interpreted by the database server, each data block row yields data from at least a portion of a table. As implied by the name "data block row," a single data block row holds raw data corresponding to a single row of a table. However, there is not always a one-to-one correspondence between table rows and data block rows.

For example, table 800 is comprised of rows 801-805, organized into columns 811-815. The data for table rows 801-805 is stored in data block rows 821-824 and 831-832. Specifically, each data block row 821-824 and 831-832 comprises multiple fields 890. Each field 890 corresponds to a single column value from table 800. While data block rows 821, 822, 823, and 832 have a one-to-one correspondence with table rows 801, 802, 803, and 805 respectively, the data for table row 804 is divided amongst data block rows 824 and 831. When data for a table row is divided amongst multiple data block rows in different data blocks, the table row is said to chained across the multiple data blocks, and the data block rows may be referred to collectively as a chain.

Although "rows" in a table and "rows" in a data block are both commonly known as "rows," it should by now be apparent that the two types of "rows" are distinct concepts. To avoid confusion, this application shall therefore, where necessary, use the terms "table row" and "data block row," respectively, to refer to "rows" of a data block and "rows" of a table.

In some databases, each data block row is delimited by a row header. Each row header may contain a variety of metadata, including an identifier for the data block row, the number of columns that the database server should expect to read from the data block row, and/or the sizes of each column in the data block row (thereby instructing the database server as to the boundaries of each field in the data block row). For example, each of data block rows 821-824 and 831-832 include a data block row header 821a-824a or 831a-832a. In some embodiments, the size (or length) of each column is instead inserted as a separate field of predefined length that immediately precedes each column field in the data block row.

In some databases, when data for a table row is chained over multiple data block rows (because of, for instance, size or column count limitations), the database may also store metadata associating one or more of the data block rows with one or more other data block rows in which data for the same table row is held. This metadata may be in any location, such as in the row header, data block header, or at the end of the data block row. For instance, pointer 829 in data block row 824 points to data block row 831, which comprises the remaining data values of table row 804.

Data blocks may also have headers and/or other data structures that describe information about the data block and/or the tables whose raw data they hold. For instance, data blocks 820 and 830 comprise header data 825 and 835, respectively. A data block header may, for instance, include metadata such as a table directory that describes various qualities of the tables and table rows for which its data block comprises data. A data block header may also, for instance, include metadata such as a row directory indicating the starting address of and/or an identifier for each data block row in the data block.

The metadata in a data block's header (or in an equivalent structure) may, in some databases, define and delimit the data block rows for the data block. Thus, in some databases, a data block row may be characterized as the lowest level subdivision of a data block whose address is discernable from the data block's header, or as any subdivision of the data block for which the data block header lists an indexable identifier.

Data blocks 820 and 830 are organized in a format known as "row major," and may therefore be described as "row major data blocks." The format is known as "row major" because each data block row 821-824 and 831-832 contains data from only a single row of the table. Other databases may instead store tables within data blocks using other formats, including formats such as "column major." The techniques described herein are applicable to any type of data block, regardless of the format used.

Note that table 800 and data blocks 820-830 are each relatively small in size. This application equally contemplates the use much larger tables and much larger data blocks. However, for the purposes of clarity, the example tables and data blocks herein are relatively simple.

### ADDRESSING DATA FROM DATA BLOCKS

A database may store a variety of metadata to assist a database server in interpreting the data stored within the database's data blocks. For example, various indexes may comprise mapping data associating each table in the database with one or more data blocks. As another example, various indexes may comprise mapping data that associates table rows with data row blocks.

For example, index 850 of FIG. 8 comprises a list 851 of table rows in table 800, along with addresses 852 of data block rows that contain data for the table rows. Addresses 852-which may also be described as rowids-are each comprised of two elements: a data block identifier, consisting of numbers before the period, and a data block row identifier, consisting of numbers after the period. However, other addressing schemes may also be used.

A database server may utilize such metadata to locate data blocks and/or data block rows that store data for tables and table rows. For example, the database server may require access to data from table row 801 of FIG. 8. Using index 850, the database server may determine that data for table row 801 is in the first data block row of data block 820 (i.e. data block row 821). The database server may then utilize a data block identifier-to-address mapping or algorithm to locate data block 820 on disk. The database server may then utilize other mapping data (such as data in the data block header mapping the data block row identifier to a block-relative address) to locate the start of the first data block row in data block 820. The database server may then read and interpret this row, thereby producing the data for table row 801.

For table rows whose data spans multiple data block rows, row indexes such as index 850 may point only to the data block row that comprises data for the first portion of the table row. Upon determining that the table row is not fully represented by the values in the data block row, the database server may utilize metadata such as pointer 829 to ascertain the location of other data block rows that comprise additional data for the table row. For example, in locating data for table row 804, a database server may be first directed to data block row 824. The database server may then follow pointer 829 to data block row 831, which comprises the remaining data for table row 804.

### COMPRESSED DATA BLOCKS

In some databases, the raw data within each data block may be compressed at the block level. For example, if the word "San Jose" appears multiple times within a data block, the data block may substitute each occurrence of "San Jose" with a symbol or smaller set of characters, such as "@1," and then store a decompression dictionary (also known as a symbol table) that associates "@1" with "San Jose." As the database server interprets a data block row that contains such compressed values, the database server may utilize the decompression dictionary to interpret compressed values. In some databases, the decompression dictionary is localized for each block and then stored inside of the block itself (for example, in the data block header). In other databases, the decompression dictionary is shared amongst multiple data blocks, and thus stored in its own block, separate from the multiple data blocks. Such compression schemes shall hereinafter be referred to as "block-based compression."

### CONTENTS OF THE INVENTION

A method and computer system for more efficiently storing shredded XML documents is provided. The method includes loading each XML document of a plurality XML documents into a plurality of rows in a table in which XML documents are stored in shredded form. Loading said each XML document comprises generating column values of a plurality columns, said column values to be stored in a plurality of rows in the table. Loading said each XML document also comprises, for each column of said plurality of columns, analyzing said column values to make a determination of a row-storage format for storing said columns. Making the determination includes determining whether to store column values in column-major or row-major format, and determining whether to use a compression technique to compress said column values. Loading said each XML document also comprises storing the column values in the plurality of rows according to said determination of storage format. The method is performed by one or more computing devices. In one embodiment, a computer program product stores instructions which, when executed, cause one or more processors to perform the method.

The computer system includes means for loading each XML document of a plurality XML documents into a plurality of rows in a table in which XML documents are stored in shredded form. The means for loading said each XML document comprises means for generating column values of a plurality columns, said column values to be stored in a plurality of rows in the table. The means for loading said each XML document also comprises means for analyzing, for each column of said plurality of columns, said column values to make a determination of a row-storage format for storing said columns. The means for analyzing includes means for determining whether to store column values in column-major or row-major format, and means for determining whether to use a compression technique to compress said column values. The means for loading said each XML document also comprises means for storing the column values in the plurality of rows according to said determination of storage format.

The doctoral thesis "Query execution in column-oriented database systems" by Daniel J. Abadi, February 2008, XP55003471, discloses a database system with a storage layer and a query executer built for storing tables in a column-by-column layout. The performance of this database system is benchmarked against a more usual database system that stores tables row-by-row. Furthermore, techniques to implement a column-store database design in a commercial row-oriented database system are disclosed, as are data compression techniques and various other optimizations.

The article "Storing and querying XML data using an RDBMS" by D. Florescu et al., Quarterly Bulletin of the Computer Society of the IEEE Technical Committee on Data Engineering, vol. 22, no. 3, September 1999, pages 27-34, XP002274305, discloses techniques for storing and querying XML data using an RDBMS. It is disclosed that either the edges of the graph that represents an XML document are stored in a single table, or all edges with the same label are grouped into one table, or a universal table is used to store all edges. Similarly, separate value tables may be established for each conceivable type of the values of an XML document, or the values and attributes may be stored in the same tables.

US 2009/0287737 A1 discloses an object-oriented database running on an RDBMS. Most of the tables utilize a row-major form, but for certain tables a column-major form is used for storage.

### SUMMARY

The present invention in defined by the independent claims. The dependent claims concern optional features of some embodiments of the invention.

### BRIEF DESCRIPTION OF THE DRAWINGS

The present invention is illustrated by way of example, and not by way of limitation, in the figures of the accompanying drawings and in which like reference numerals refer to similar elements and in which:
FIG. 1 depicts a procedure for separately analyzing the column values generated for a XML document and determining a major format and compression technique, according to an embodiment of the present invention;
FIG. 2 is a block diagram of a compression unit;
FIG. 3 is a block diagram of a table that is referred to in examples provided herein;
FIG. 4 is a block diagram showing two levels of compression units;
FIG. 5 is a block diagram showing how tabular data from the table illustrated in FIG. 2 may be stored in the compression units illustrated in FIG. 3;
FIG. 6 is a block diagram illustrating how child compression units may themselves have child compression units;
FIG. 7 is a block diagram illustrating how a compression unit header is split into two portions, one of which is uncompressed and one of which is compressed;
FIG. 8 illustrates how an uncompressed table may be stored in example data blocks; and
FIG. 9 is a block diagram of a computing device upon which embodiments of the invention may be implemented.

### DETAILED DESCRIPTION

In the following description, for the purposes of explanation, numerous specific details are set forth in order to provide a thorough understanding of the present invention. It will be apparent, however, that the present invention may be practiced without these specific details. In other instances, well-known structures and devices are shown in block diagram form in order to avoid unnecessarily obscuring the present invention.

### GENERAL OVERVIEW

Described in here are mechanisms for more efficiently storing shredded XML documents. The mechanisms exploit the power of compression and a form of storing relational data referred to as column-major format, to store XML documents in shredded form. The column values that are to be stored for shredded XML documents are separately analyzed for each XML document to determine whether to store a particular column in column-major format and what compression technique to use, if any.

Data in a database is stored persistently in persistent storage units having one of a set of enumerated sizes. (e.g. 4k data blocks, 32 k data blocks). There are several forms of storing rows in persistent storage units: row-major and column-major. In row-major format, column values of a single row are stored contiguously within a unit of persistent storage, such as a data block. In column-major format, values of a column of multiple rows are stored contiguously. Row-major format or column-major format are collectively referred to herein as major formats.

In column-major format incoming data is rearranged so that data belonging to one column is placed together. As data in one column is very likely to be similar, this reduces entropy and hence achieves better compression ratios. This is similar to vertical partitioning or columnar storage.

Column-major format has the advantage that it permits better compressibility. The values within a column may have common properties such that, when the values are stored contiguously, the common properties can be exploited using various compression techniques. The major format of a column and the compression technique used, if any, is referred to herein as a storage format.

According to an embodiment of the present invention, when shredding an XML document, the column values to store in rows that will hold the shredded XML document are analyzed to determine the storage format, i.e. whether and/or how to store the rows in row-major or column-major format, and what compression technique to apply, if any. In this way, the column values for a column and particular XML document are separately analyzed to determine a storage format for the rows that hold that XML document's data.

An embodiment of the present invention is illustrated within the context of a database system that supports relational storage, querying and manipulation of data and supports storage and querying of XML data according to XML standards. Therefore, a description of such database systems is useful.

### DATABASE SYSTEMS

A database management system ("DBMS") manages a database. A database management system may comprise one or more database servers. A database comprises database data and metadata that is stored on a persistent memory mechanism, such as a set of hard disks. Metadata defines database objects, such as relational tables, table columns, view, and triggers.

Database applications and clients interact with a database server by submitting to the database server commands that cause the database server to perform operations on data stored in a database. A database command may be in the form of a database statement that conforms to a database language. A language for expressing database requests is the Structured Query Language (SQL). There are many different versions of SQL, some versions are standard and some proprietary, and there are a variety of extensions. SQL data definition language ("DDL") instructions are issued to a database server to create or configure database objects, such as tables, views, or complex data types. SQL/XML is a common extension of SQL used when manipulating XML data in an object-relational database. Although the examples are described based on Oracle's SQL, the techniques provided herein are not restricted to any particular version of SQL.

### XML STORAGE

Various types of storage mechanisms are used to store a XML document. One type of storage mechanism stores a XML document as a text file in a file system. As mentioned previously, another type of mechanism for storing XML documents is a database server. In a database server, a XML document may be stored in a row of a table and nodes of the XML document are stored in separate columns in the row. An entire XML document may also be stored in a lob (large object) in a column. A XML document may be shredded and stored as a hierarchy of objects in a database; each object is an instance of an object class and stores one or more elements of a XML document. Tables and/or objects of a database system that hold XML data are referred to herein as base tables or objects.

Binary-encoded XML is another form in which XML data may be stored in a database. Binary-encoded XML is a compact binary representation of XML that was designed to reduce the size of XML documents. One of the ways binary-encoded XML compresses data is by representing strings ("tokens") with fixed values.

### XML INDEX

Database servers that store XML data may include many mechanisms that allow for powerful and efficient ways to query large collections of XML documents. Database servers that store XML documents may be enhanced to efficiently perform XML operations using these mechanisms. A database server may maintain a "logical index", referred to herein as a XML index, that indexes a collection of XML documents.

An XML index contains multiple structures that are cooperatively used to access a collection of XML documents. One such structure is a relational table that stores shredded documents. Such a relational table is used to illustrate an embodiment of the present invention.

Specifically, an XML index may include a table referred to as a path table. The path table stores shredded documents, which are referred to herein as indexed documents. Each row of the path table contains data for a node of an indexed document. Not all nodes of an indexed document have a corresponding row in the path table.

Each path table row contains multiple columns, each column of a row containing a piece of information associated with a node. Some of the values of columns are amenable to compression under column-major format.

According to an embodiment, the columns of a path table include a column for (1) a PATHID that indicates the path to the node, (2) "location data" for locating the fragment data for the node within the base structures, and (3) "hierarchy data" that indicates the position of the node within the structural hierarchy of the XML document that contains the node. Optionally, the PATH table may include a column that contains value information for those nodes that are associated with values. Each of these types of information shall be described in greater detail below.

### PATH IDS

According to an embodiment, each of the indexed XML paths is assigned a unique path ID. For example, the paths that exist in po1.xml and po2.xml may be assigned path IDs as illustrated in the following table:

| PATH ID | PATH |
|---|---|
| 41 | /PurchaseOrder |
| 41.54 | /PurchaseOrder/Reference |
| 41.34 | /PurchaseOrder/Actions |
| 41.34.33 | /PurchaseOrder/Actions/Action |
| 41.34.33.77 | /PurchaseOrder/Actions/Action/User |

Various techniques may be used to identify paths and assign path IDs to paths.

### LOCATION DATA

The location data associated with a node indicates where the XML document that contains the node resides within the base structures. Thus, the nature of the location data will vary from implementation to implementation based on the nature of the base structures. Depending on how the actual XML document is stored, the location data may also include a locator or logical pointer to point into the XML document. The logical pointer may be used for extracting fragments that are associated with nodes identified by XPaths.

### HIERARCHY DATA

The PATH table row for a node also includes information that indicates where the node resides within the hierarchical structure of the XML document containing the node. Such hierarchical information is referred to herein as the "OrderKey" of the node.

According to one embodiment, the hierarchical order information is represented using a Dewey-type value. Specifically, in one embodiment, the OrderKey of a node is created by appending a value to the OrderKey of the node's immediate parent, where the appended value indicates the position, among the children of the parent node, of that particular child node.

According to one embodiment, the composite numbers represented by each OrderKey are converted into byte-comparable values, so that a mathematical comparison between two OrderKeys indicates the relative position, within the structural hierarchy of an XML document, of the nodes to which the OrderKeys correspond.

### VALUE INFORMATION

Some nodes within an indexed document may be attribute nodes or nodes that correspond to simple elements. According to one embodiment, for attribute nodes and simple elements, the PATH table row also stores the actual value of the attributes and elements. Such values may be stored, for example, in a "value column" of the PATH table. The secondary "value indexes", which shall be described in greater detail hereafter, are built on the value column.

### PATH TABLE EXAMPLE

An embodiment of the present invention is illustrated with a path table example that includes columns defined as follows:

| **Column Name** | **Datatype** | **Description** |
|---|---|---|
| PATHID | RAW(8) | ID for the path token. Each distinct path e.g. /a/b/c is assigned a unique id by the system. |
| RID | UROWID / ROWID | Rowid of the row in base table. |
| ORDER_KEY | RAW(100) | Dewey order key for the node e.g. 3.21.5 to indicate 5^{th} child of 21^{st} child of 3^{rd} child of root. |
| LOCATOR | RAW(100) | Information corresponding to the starting position for the fragment. This is used during fragment extraction. |
| VALUE | RAW(2000) / | Value of the node in case of attributes and simple elements. |
| | BLOB | The type can be specified by the user (as well as the size of the RAW column) |

As explained above, the PATHID is a number assigned to the node, and uniquely represents a fully expanded path to the node. The ORDER_KEY is a system representation of the DEWEY ordering number associated with the node. The VALUE column stores the effective text value for simple element (i.e. no element children) nodes and attribute nodes.

The path table example shall be given hereafter with reference to the following two illustrative XML documents:

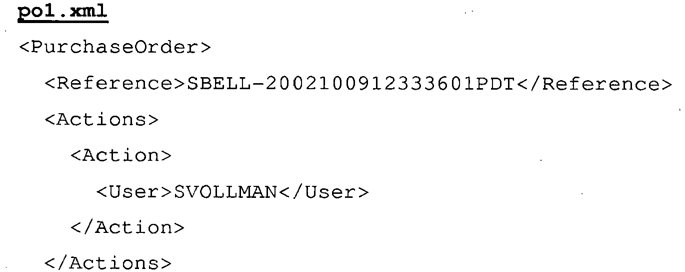

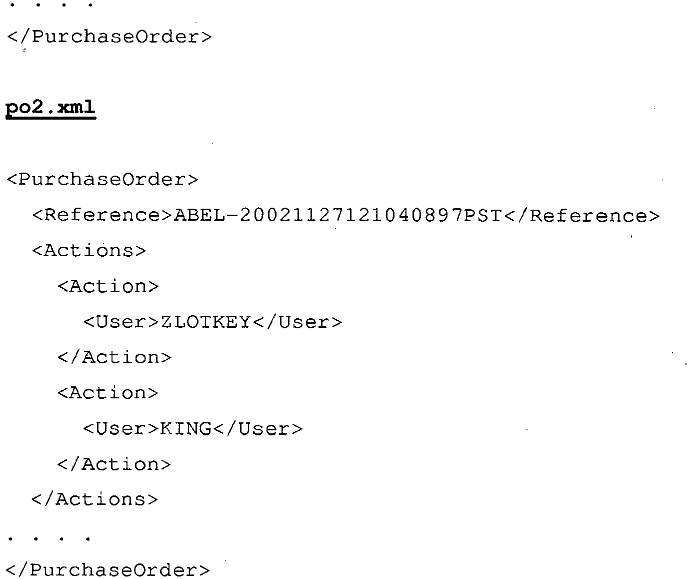

The following table is an example of rows of the path table example that are populated with entries for po1.xml and po2.xml. Specifically, each row of the PATH table corresponds to an indexed node of either po1.xml or po2.xml.

### POPULATED PATH TABLE EXMAMPLE

| **PATHID** | **RID** | **OrderKey** | **Locator** | **Value** |
|---|---|---|---|---|
| 41 | 346.1.27 | 1 | | |
| 41.54 | 346.1.27 | 1.1 | | SBELL-2002100912333601PDT |
| 41.34 | 346.1.97 | 1.2 | | |
| 41.34.33 | 346.1.97 | 1.2.1 | | |
| 41.34.33.77 | 346.1.97 | 1.2.1.1 | | SVOLLMAN |
| 41 | 346.2.97 | 1 | | |
| 41.54 | 346.2.97 | 1.1 | | ABEL-20021127121040897PST |
| 41.34 | 346.2.27 | 1.2 | | |
| 41.34.33 | 346.2.27 | 1.2.1 | | |
| 41.34.33.77 | 346.2.27 | 1.2.1.1 | | ZLOTKEY |
| 41.34.33 | 346.2.27 | 1.2.2 | | |
| 41.34.33.77 | 346.2.27 | 1.2.2.1 | | KING |

In this example, rows 1 - 5 store a shredded version of po1.xml. Rows 6 - 12 store a shredded version of po2.xml. In the base table that stores these XML documents, both documents are stored in same block 346, but in different rows within the block.

When column values of certain columns in the path table are stored contiguously within a data block, the common properties between the values may be exploited for compression. For example, the values in RID are amenable to Run Length Coding (RLC). Run-length coding is a very simple form of data compression in which runs of data (that is, sequences in which the same data value occurs in many consecutive data symbols) are stored as a single data value and count, rather than as the original run. In addition, different compression techniques may be used for the same column for different XML documents. In XML documents where the same path appears frequently, a run-length encoded schema might be used. In highly nested documents, in which the same path prefix is shared by numerous nodes, a prefix based compression schema might be more efficient. All Path IDs with the same prefix are compressed by storing the prefix just once.

### COMPRESSION UNITS

As mentioned earlier, data in a database is stored persistently in persistent storage units (e.g. data blocks) having one of a set of enumerated sizes. According to an embodiment of the present invention, the storage units are referred to herein as compression units. Compression units are highly flexible structures for physically storing tabular data, such as rows of a table.

According to an embodiment, each compression unit stores data for all columns of the corresponding table. For example, if a table has twenty columns, then each compression unit for that table will store data for different rows, but each of those rows will have data for all twenty columns. Within the compression unit, data may be stored in column-major format, or row-major format.

However, for a set of rows in a table, data for the rows may be divided among compression units based on columns. Thus, some compression units may store data for a first column of the table in column-major format, some may store data for a second column of the table in column major format, while other compression units store data for the third and fourth columns of the table in row-major format. In such an embodiment, a single row of the table may be spread among several compression units. Importantly, compression units that store data first column may use different compression algorithm than that used to compress data in the compression units that hold the second column. Further details on compression units can be found in *Structure of Hierarchical Compressed Data Structure for Tabular Data.*

According to an embodiment of the present invention, while shredding an XML document to store in a path table, the values to be stored in a particular column are examined and analyzed to determine what major format to use, and what if any compression technique to use. All column values for each column in the table are examined. In this way, an individual XML document is separately analyzed to determine a storage format specific to the XML document.

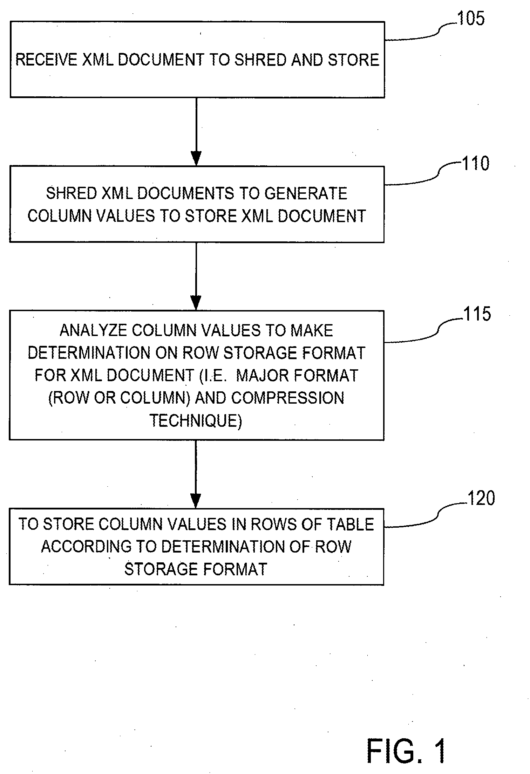

FIG. 1 is a diagram that depicts such a procedure for shredding an XML document and determining a storage format. According to an embodiment, the steps may be performed by a database server that has been enhanced to handle XML storage. The steps are illustrated in the context of loading an XML document in a path table.

Referring to FIG. 1, at 105, a database server receives a XML document to store in shredded form.

At 110, the database server shreds the XML document to generate values to store in the XML index. For each node to store therein, the column values for a row are generated. These include columns values for columns PATHID, RID, ORDER_KEY, LOCATOR, VALUE.

At 115, the database server analyzes the column values to determine the row storage format for the rows, that is, to use row-major format for one or more or all of the columns, whether to use column-major format for one or more of the columns, and what compression technique to use. For example, for a large document stored in a base table, there are a lot of nodes to store in the path table that all have the same value for RID column. Therefore, column-major format using run length compression is used. For the PATH ID column, there may be a large subtree with nodes whose path ascends through the same root and an immediate descendant node. The column for PATH ID may be stored in column-major format using, for example, run-length or compression prefix-based compression, as mentioned earlier. In cases where a single number denotes the entire path, any standard number compression scheme (run length encoding of the digits, binary values etc) can be applied.

At 120, the database server stores the column values in a database according to the storage format determined at step 115. In an embodiment, the rows are stored using a row-batch insert function or procedure that is invoked to store a batch of rows into the same set of compression units. The compression units are a form of data blocks in the database. The data blocks are only populated with the rows in the batch. The row-batch insert function accepts parameters for controlling the major format of specific columns, and the compression technique to use.

Using the techniques described herein for document-specific storage formatting, storage formats of different XML documents stored in a path table may differ. Rows for one XML document may all be stored in row-major format. For a second XML document, rows may have columns that are each in column-major format. For the rows that store a third XML document, the same columns as for the second document are stored in column-major format, but are compressed using at one least one different compression technique.

### STORING TABULAR DATA IN COMPRESSION UNITS—MORE DETAILS

Computers are used to store and manage many types of data. Tabular data is one common form of data that computers are used to manage. Tabular data refers to any data that is logically organized into rows and columns. For example, word processing documents often include tables. The data that resides in such tables is tabular data. All data contained in any spreadsheet or spreadsheet-like structure is also tabular data. Further, all data stored in relational tables, or similar database structures, is tabular data.

Logically, tabular data resides in a table-like structure, such as a spreadsheet or relational table. However, the actual physical storage of the tabular data may take a variety of forms. For example, the tabular data from a spreadsheet may be stored within a spreadsheet file, which in turn is stored in a set of disk blocks managed by an operating system. As another example, tabular data that belongs to a relational database table may be stored in a set of disk blocks managed by a database server.

How tabular data is physically stored can have a significant effect on (1) how much storage space the tabular data consumes, and (2) how efficiently the tabular data can be accessed and manipulated. If physically stored in an inefficient manner, the tabular data may consume more storage space than desired, and result in slow retrieval, storage and/or update times.

Often, the physical storage of tabular data involves a trade-off between size and speed. For example, a spreadsheet file may be stored compressed or uncompressed. If compressed, the spreadsheet file will be smaller, but the entire file will typically have to be decompressed when retrieved, and re-compressed when stored again. Such decompression and compression operations take time, resulting in slower performance.

The best compression/performance balance is particularly difficult to achieve when tabular data includes various different types of data items. For example, a spreadsheet may include some columns that contain character strings, some columns that contain images, and yet other columns that contain binary Yes/No indications. The character strings may be highly compressible using a particular compression technique, but applying the same compression technique to the other types of data in the spreadsheet may yield no benefit. On the other hand, the images contained in the spreadsheet may be highly compressible using a compression technique that yields no benefit when used on character strings. Under circumstances such as these, whether the user chooses to compress the spreadsheet file using one of the techniques, or not at all, the result is inevitably sub-optimal.

A highly flexible and extensible structure is provided for physically storing tabular data. The structure, referred to herein as a "compression unit", may be used to physically store tabular data that logically resides in any type of table-like structure. For example, compression units may be used to store tabular data from spreadsheets, relational database tables, or tables embedded in word processing documents. There are no limits with respect to the nature of the logical structures to which the tabular data that is stored in compression units belongs.

According to one example, compression units are recursive. Thus, a compression unit may have a "parent" compression unit to which it belongs, and may have one or more "child" compression units that belong to it. There is no limit to the number of recursive levels of compression units that may be used to store tabular data. For the purpose of explanation, a compression unit that has no parent is referred to herein as a "top-level" recursive unit, while a compression unit that has no children is referred to herein as a "bottom-level" compression unit.

According to one example, each top-level compression unit stores data for all columns of the corresponding table. For example, if a table has twenty columns, then each toplevel compression unit for that table will store data for different rows, but each of those rows will have data for all twenty columns. However, in alternative embodiments, even at the top-level, data from a table may be divided among compression units based on columns. Thus, some toplevel compression units may store data for the first ten columns of a table, while other top-level compression units store data for the second ten columns of the table. In such an embodiment, a single row of the table may be spread among several top-level compression units.

In one example, compression units include metadata that indicates how the tabular data is stored within them. The metadata for a compression unit may indicate, for example, whether the data within the compression unit is stored in row-major or column major format (or some combination thereof), the order of the columns within the compression unit (which may differ from the logical order of the columns dictated by the definition of their logical container), a compression technique for the compression unit, the child compression units (if any), etc.

Techniques are also described hereafter for storing tabular data into compression units, retrieving data from compression units, and updating tabular data in compression units. According to one example, techniques are employed to avoid changing tabular data within existing compression units. For example, deleting tabular data within compression units is avoided by merely tracking deletion requests, without actually deleting the data. As another example, inserting new tabular data into existing compression units is avoided by storing the new data external to the compression units. If the number of deletions exceeds a threshold, and/or the number of new inserts exceeds a threshold, new compression units may be generated. When new compression units are generated, the previously-existing compression units may be discarded to reclaim storage, or retained to allow reconstruction of prior states of the tabular data.

### COMPRESSED AND UNCOMPRESSED SECTIONS

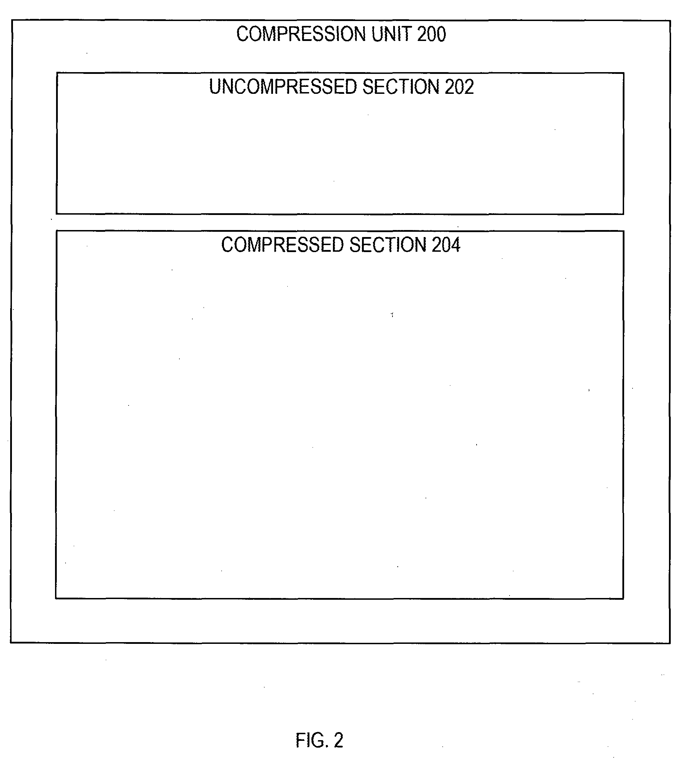

FIG. 2 is a block diagram of a compression unit 200 according to one example. In the example illustrated in FIG. 2, compression unit 200 has two primary sections: an uncompressed section 202 and a compressed section 204. In general, the uncompressed section 202 includes metadata about the contents and format of the compressed section 204. Uncompressed section 202 may indicate, for example, what compression technique (if any) was used to compress the contents of the compressed section 204, and how the contents of uncompressed section 202 are organized.

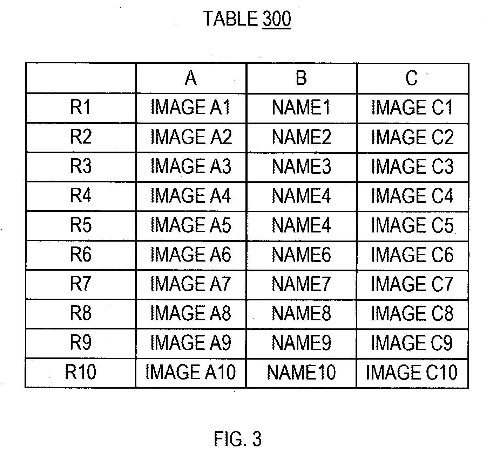

For example, assume that compression unit 200 is used for storing tabular data from the table 300 that is illustrated in FIG. 3. Table 300 has three columns A, B, C and ten rows R1-R10. For the purpose of explanation, assume that all of the data from Table 300 is stored in compression unit 200, and that compression unit 200 is both a top-level compression unit (has no parent) and a bottom-level compression unit (has no children). Under these circumstances, the uncompressed section 202 of compression unit 200 may simply include:
- an indication of the compression technique (if any) used to compress the contents of compressed section 204; and
- an indication that compression unit 200 is a bottom-level compression unit (and therefore has no children).

While these two pieces of information may be sufficient to allow use of compression unit 200, alternative examples include several additional pieces of metadata to provide greater flexibility and extensibility. For example, within any compression unit, tabular data may be stored in column-major format or row-major format. When stored in row-major format, the tabular data would be stored within compressed section 204 in the sequence IMAGE1A, NAME1, IMAGE1C, IMAGE2A, NAME2, IMAGE2C, etc. On the other hand, when stored in column-major format, the tabular data would be stored within compressed section 204 in the sequence IMAGE1A, IMAGE2A, IMAGE3A... NAME1, NAME2, NAME3... IMAGE1C, IMAGE2C, IMAGE 3C, etc. In an example that allows the columnmajor/row-major selection to be made on a compression-unit-by-compression-unit basis, uncompressed section 202 may further include an indication of whether the tabular data contained in the compressed section 204 is stored in row-major or column-major format. In one example, to conserve space, a compression unit does not include the names of the columns whose data is contained in the compression unit. Further, a compression unit may or may not store the rowids of the rows whose data is contained in the compression unit.

### RECURSIVE STRUCTURE

As mentioned above, examples shall be described herein in which compression units are recursive structures. Thus, a compression unit may have a parent compression unit and any number of child compression units. In the example given above, compression unit 200 did not have any child compression units. However, in situations in which compression unit 200 has child compression units, the compression unit 200 may include a header that has information about the child compression units. The header for compression unit 200 may be stored in the uncompressed section 202, or split between the uncompressed section 202 and the compressed section 104.

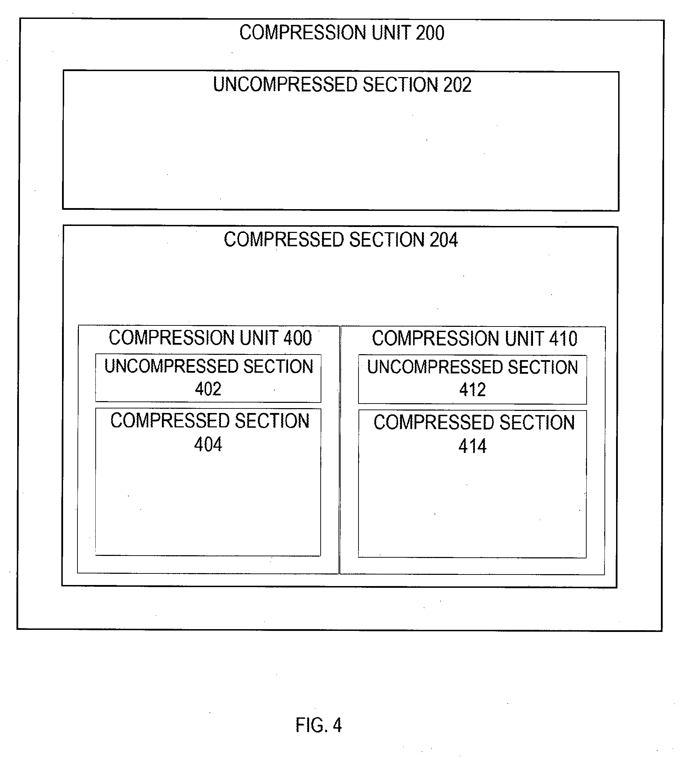

In the situation illustrated in FIG. 4, compression unit 200 has two child compression units 400 and 410. As illustrated, child compression units 400 and 410 have the same general structure as their parent compression unit 200. That is, similar to compression unit 200, child compression units 400 and 410 include uncompressed sections and compressed sections. Further, compression units 400 and 410 reside entirely within the compressed section 204 of their parent compression unit 200. Consequently, whatever compression is applied by to compressed section 204 at the level of compression unit 200 applies to the entirety of compression units 400 and 410.

Because the compression of parent compression units applies to the entirety of their child compression units, even the uncompressed sections 402 and 412 of child compression units may in fact be compressed. Thus, the "uncompressed" section of a compression unit is only uncompressed relative to the level in which the section resides (but may be compressed based on compression applied at higher level compression units). In contrast, the compressed section of a compression unit is compressed relative to the level in which the section resides (in addition to any compression applied at higher level compression units).

According to one example, when compression unit 200 is the parent of one or more child compression units, the header of compression unit 200 includes additional information. For example, the header of compression unit 200 indicates (a) an offset at which each child compression unit begins, and (b) which data is contained in each child compression unit.

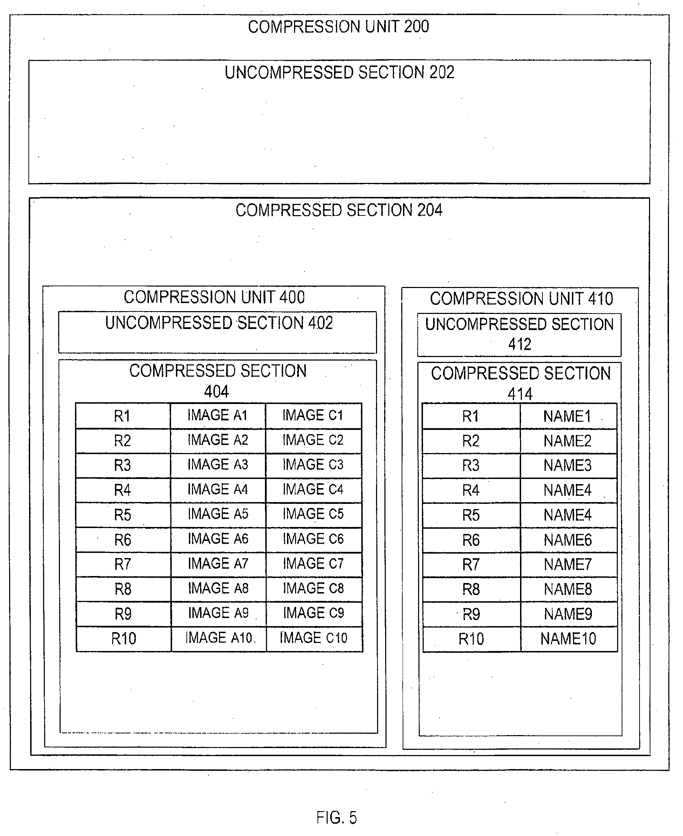

For example, assume that a particular compression technique CT1 is particularly good at compressing images. Under these circumstances, it may be desirable to compress the images in columns A and C of table 300 using compression technique CT1, while compressing the strings of column B with a different compression technique CT2. To achieve this compression combination using the two child compression units 400 and 410, compression unit 400 may be used to store the images from columns A and C, while compression unit 410 is used to store the strings from column B. This distribution of data is illustrated in FIG. 5.

According to one example, to indicate the distribution of data illustrated in FIG. 5, the header of the parent compression unit 200 would indicate that the data within compressed section 204 is stored in column-major format, and that columns A and C are stored in compression unit 400 while column B is stored in compression unit 410. The uncompressed section 402 of compression unit 400, in turn, would indicate that compression technique CT1 applies to compressed section 404. Similarly, the uncompressed section 412 of compression unit 410 would indicate that compression technique CT2 applies to compressed section 414.

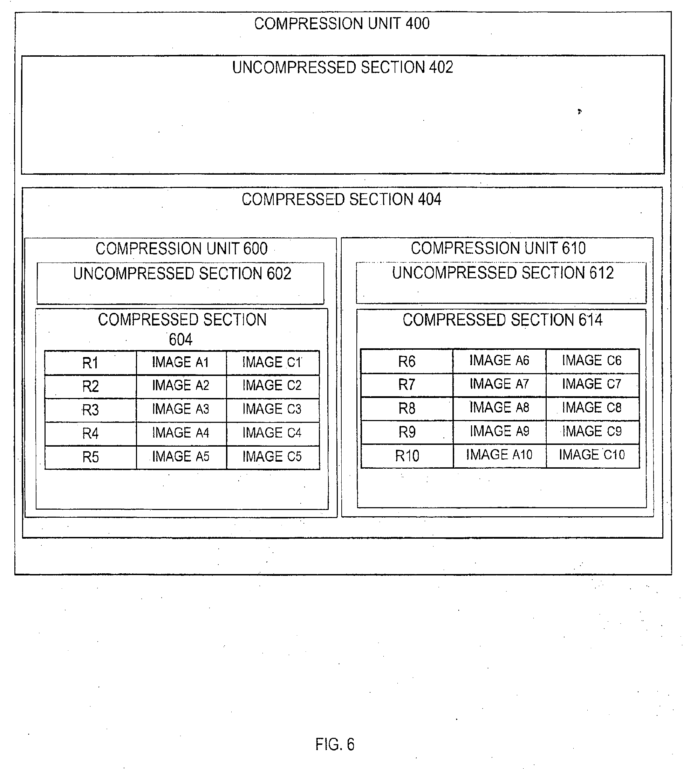

Because of the recursive nature of compression units, the compression units 400 and 410 may themselves be parents to one or more child compression units. For example, in FIG. 6, compression unit 400 is shown as having two child compression units 600 and 610. Compression unit 600 stores the images from columns A and C for rows R1 to R5, while compression unit 610 stores the images from columns A and C for rows R6 to R10. Because the data within compressed portion 404 is distributed between compression units 600 and 610 based on rows, the uncompressed section 402 of compression unit 400 would indicate that, at the level of compression unit 400, the tabular data is organized in row-major format.

In this example, compression units 600 and 610 are bottom-level compression units that are two levels below the top-level compression unit 200. On the other hand, compression unit 410 is a bottom-level compression unit that resides one level below the top-level compression unit 200. Thus, in one example, bottom-level compression units that store tabular data for the same table may be at different depths, depending on how the tabular data has been spread among compression units.

### METADATA DESCRIBING INTERNAL ORGANIZATION OF COMPRESSION UNITS

Because the information within compression units may be organized in a virtually infinite number of ways, metadata is maintained to indicate how each compression unit is organized. Depending on the implementation, the metadata about the organization of tabular data within a compression unit may be stored external to the compression unit, or within the compression unit. When stored within the compression unit, the metadata may be stored in the uncompressed section, the compressed section, or divided between both. The actual manner in which the metadata is stored may vary from implementation to implementation.

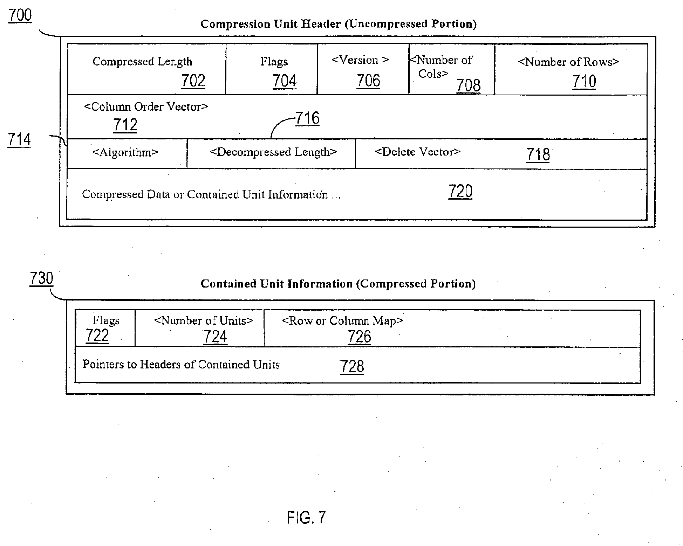

According to one example, the metadata that describes the organization of tabular data within a compression unit is stored in a header within the compression unit, and includes both an uncompressed header portion 700 and a compressed header portion 730, as illustrated in FIG. 7. In one example, the header is organized according to the H following structure:

```
      struct compression_unit_header
      {
      ub4 length;
      ub2 flag_version_number: 1;
      ub2 flag_data_or_units: 1;
      ub2 flag_col_order:1;
      ub2 flag_uncompressed:1;
      ub2 flag_num_col_less_than_256:1;
      ub2 flag_num_cols:1;
      ub2 flag_num_rows: 1;
      ub2 flag_delvec:1;
      ub2 flag_checksums: 1;
      ub2 flags:6;
      ub2 flag_more_flag_bytes: 1;
      <ub2 flags2;>
      <ub1 version;>
      <ub2 num_cols;>
      <ub2 num_rows;>
      <ub2 col_order[];>
      <ub2 algo;>
      <ub4 decomp_len;>
      <bitvec delvec[];>
      // The following bytes are compressed using algorithm defined
      in the "algo" field specified above,
      // or uncompressed if flag_uncompressed is set.
      union
      {
      ub1 data[];
      contained units units;
      } data_or_units;
      };
      typedef struct
      {
      ub1 flag_row_or_col_map: 1;
      ub1 flag_cols_same_as_units: 1;
      ub1 flags:6;
      <ub_1_2 num_units;> // 2 if num_cols > 256;
      <ub_1_2 row_or_col_map[];> // 2 if col_map and num_cols >
      256;
      compression_unit_header *unit[];
      } contained_units;
```

In an example that stores metadata within compression units according to this header structure, the initial "length" field 702 stores metadata that indicates the compressed size of the compression unit. In this context, the "compressed size" means the amount of storage occupied by the compression unit before any data contained there is decompressed. However, some compression units may not actually compress data. In such cases, the "compressed size" would be the same as the uncompressed size.

In the example illustrated in FIG. 7, the length field 702 is followed by a series of flags 704. The flags 704 indicate whether or not the header contains certain fields. When the flag associated with a field indicates that the field is not present, then the field is either not relevant to the particular compression unit, or some "default" value is assumed for the field. The flags 704, and their corresponding fields, shall be discussed hereafter in greater detail.

### THE VERSION FLAG AND FIELD

The "flag_version_number" flag indicates whether a version number field 706 is present in the header. The version number field 706 may be used in situations where the application that is managing the tabular structure (e.g. a spreadsheet program, word processor, or relational database system) supports versioning. In systems that support versioning, the version number field 706 is used to store a value that indicates the version of the tabular data contained within the compression unit. According to one example, it is assumed that child compression units are associated with the same version as their parents, so the version number field 706 need only be used in top-level compression units.

### THE DATA_OR_UNITS FLAG AND FIELDS

The "flag_data_or_units" flag indicates whether the compression unit includes fields relating to child compression units. In the example illustrated in FIG. 7, such fields include the "contained unit information" stored within the compressed header portion 730. If a compression unit is a bottom-level compression unit, then the compression unit will not have any child compression units, and therefore will not have nor require any header fields relating to child compression units.

### THE COL_ORDER FLAG AND FIELD

The "flag_col_order" flag indicates whether the header contains a column order vector 712. If the flag_col_order flag is false, then it is assumed that the columns are organized within the compression unit in the same column order as the "parent column order". For child compression units, the parent column order is the column order specified by its parent compression unit. For top-level compression units, the column order is the column order defined by the tabular structure itself.

For example, the column order defined for table 300 is A, B, C. Therefore, the parent column order for compression unit 100, which is a top-level compression unit, is A, B, C. If the flag_col_order flag for compression unit 100 is false, then it would be assumed that the column order within compression unit 100 is A, B, C. However, as illustrated in FIG. 4, within compression unit 100 the columns are ordered A, C, B (where columns A and C are stored in child compression unit 300. Thus, for compression unit 100, the flag_col_order would be true, and compression unit 100 would have a column order vector 612 to indicate that the mapping between the parent column order A, B, C and the new column order A, C, B.

The column order vector 712 may indicate the mapping between column orders in a variety of ways. According to one example, the positions in the column order vector 712 correspond to the columns in the parent column order. Thus, the first, second and third positions within the column order vector 712 correspond to columns A, B, and C, respectively. However, the values stored at those positions in the column order vector 712 indicate the new order of the columns. For example, in the new column order (A, C, B) imposed by compression unit 200, column A is still the first column. Thus, the first position of the column order vector would store a "1".

On the other hand, in the new column order (A, C, B) imposed by compression unit 200, column B is now third in the sequence. Consequently, the second position in the column order vector 712 would store the value "3".

Finally, in the new column order (A, C, B) imposed by compression unit 200, column C is now second in the sequence. Consequently, the third position in the column order vector 712 would store the value "2".

Thus, the column order vector "1,3, 2" within compression unit 200 would indicate that compression unit 200 has changed the order of the columns from the parent column order A, B, C, to the new column order A, C, B.

Metadata that remaps the parent column order in this manner is merely one example of metadata that may be used to indicate the column sequence used within a compression unit. Numerous alternatives may be used. For example, the header may simply store a sequence of column identifiers, where the column identifiers uniquely identify columns and the sequence of the identifiers indicates the sequence of the column data within the compression unit.

### THE UNCOMPRESSED FLAG AND FIELD

The "flag_uncompressed" flag indicates whether the unit is compressed or uncompressed. If the uncompressed flag is true, then the "compressed portion" of the compression unit is not actually compressed at the current level. However, as pointed out above, even an "uncompressed" compression unit may be compressed if it is the descendent of any compression unit that does apply compression. Similarly, an "uncompressed" compression unit may store data in child compression units that do apply compression. Thus, the uncompressed flag only indicates whether compression occurs relative to the level of the compression unit to which the flag belongs.

If the uncompressed flag is true, then the header of the compression unit will not have a compression algorithm field 714. On the other hand, if the uncompressed flag is false, then the header of the compression unit will include a compression algorithm field 714. When present, the compression algorithm field 714 indicates the compression algorithm that was used to compress the compressed section of the compression unit.

The compression algorithm used to compress the compressed section of a compression unit is distinct from any compression that may be applied by any parent compression unit, and from any compression that may be applied by any child compression unit. For example, the header of compression unit 200 may indicate that compression technique X was used to compress compressed section 204 of compression unit 200. The header of compression unit 400 may indicate that compression technique Y was used to compress compressed section 404 of compression unit 400. Finally, the header of compression unit 410 may indicate that the compressed section 414 of compression unit 410 is actually uncompressed. Under these conditions, the data within compressed section 404 will actually be double compressed, first as part of compressed section 404 using compression technique Y, and then as part of compressed section 204 using compression technique X.

### THE NUM_COL_LESS_THAN_256 FLAG AND FIELD

The "flag_num_col_less_than_256" flag indicates whether the number of columns is less than 256. If this flag is true, one byte is used for the column numbers, instead of two. Using only one byte to represent column numbers under these circumstances is another way of reducing the total size of a compression unit.

### THE NUM_COLS FLAG AND FIELD

The "flag_num_cols" flag indicates whether the unit contains information on the number of columns contained in the unit. The flag_num_cols flag may be false, for example, if the compression unit has exactly the same number of columns as its parent. For top-level compression units, the flag_num_cols may be false if the compression unit contains all of the columns of the spreadsheet and/or table for which the compression unit is storing tabular data.

In the example illustrated in FIG. 5, the flag_num_cols of compression unit 200 would be false because compression unit 200 has all of the columns of table 300. However, the flag_num_cols of compression units 400 and 410 would both be true, because they do not have the same number of columns as their parent compression unit 200.

### THE NUM_ROWS FLAG AND FIELD

The "flag_num_rows" flag indicates whether the unit contains information on the number of rows contained within the compression unit. Similar to the "flag_num_cols" flag, the flag_num_rows flag may be false if (a) the compression unit stores all of the rows of its parent compression unit, or (b) the compress unit is a top-level compression unit that stores all of the rows of the spreadsheet and/or table for which the compression unit is storing tabular data.

In the example illustrated in FIG. 5, the flag_num_rows flag of compression units 200, 400 and 410 would all be false, because all of them have all rows of table 300. However, in compression units 600 and 610 of FIG. 6, the flag_num_rows flag would be true, because compression units 600 and 610 have subsets of the rows of their parent compression unit 400.

### THE DELVEC FLAG AND FIELD

The flag_delvec flag indicates whether there is a delete vector field 718 in the header. As shall be described in greater detail hereafter, the delete vector field 718 may be used to store a delete vector that indicates that information has been deleted from the compression unit, without actually deleting the corresponding data.

### THE CHECKSUM FLAG AND FIELD

The Flag_checksum flag indicates whether there are row checksums in the compression unit. Row checksums may be used to determine whether data has become corrupted. However, row checksums consume space, and therefore may be omitted under some situations or implementations.

### THE MORE_FLAG_BYTES FLAG

The flag_more_flag_bytes flag indicates whether more flag bytes are present in the header. The ability for the current header to support additional flags in the future increases the extensibility of the compression unit structure. For example, if in the future it is determined that adding five new flags to the header of compression units may significantly improve performance, then those new flags may be added to new compression units without creating compatibility problems with existing compression units.

Specifically, the newly extended compression units would have the flag_more_flag_bytes set to true, indicating to existing applications that more flags are present. Consequently, the existence of such new flags should not confuse applications that are designed to work with the older compression unit format. On the other hand, applications designed to take advantage of the new flags will not be confused by compression units that do not have the new flags, because those compression units will have flag_more_flag_bytes set to false.

If flag_more_flag_bytes is true, then in one example the new flag bytes immediately follow the first two flag bytes. The last flag in the new set of flag bytes may be yet another flag_more_flag_bytes flag. By including such a flag at the end of each set of flag bytes, the number of flag bytes used in the header may be extended indefinitely, to allow the header to be extended as future needs arise to support any number of flags.

### CONTAINED UNIT INFORMATION

If a compression unit contains no smaller units, then the (compressed) data for the unit is at the start of the compressed section of the unit, immediately following the compression unit header 700. On the other hand, if the compression unit does contain lower-level units, then instead of starting with the data, the compressed section of the unit starts with a (compressed) data structure with information on the contained units. One example of such a contained units structure is illustrated in FIG. 7 as contained unit information 730.

In the illustrated example, the contained unit information 730 starts with flags 722. In one example, the first flag indicates whether the unit is divided based on rows or columns. The second flag indicates whether there is one column per unit. Thus, if contained unit information 730 is for a compression unit that contains three columns A, B and C, and each of the columns is in a different child compression unit, then the first flag of flags 722 would indicate that the data is divided based on columns, and the second flag of flags 722 would indicate that there is one column per child compression unit.

On the other hand, if contained unit information 730 is for a compression unit that contains three columns A, B and C, but columns A and C are in the same child compression unit, then the first flag of flags 722 would indicate that the data is divided based on columns, and the second flag of flags 722 would indicate that there is not one column per child compression unit.

In the illustrated example, the flags 722 are followed by a number of units field 724. The number of units field 724 indicates the number of child compression units, and may be either one byte or two bytes long, depending on the number of child compression units.

The number of units field 724 is followed by a map 726 either from rows to units, or from columns to units, depending on whether the data is divided by rows or by column. For example, map 726 for compression unit 200, illustrated in FIG. 5, would indicate that columns A and C are stored in child compression unit 400, and that column B is stored in child compression unit 410. On the other hand, map 726 for compression unit 400, illustrated in FIG. 6, would indicate that rows R1-R5 are stored in child compression unit 600, and that rows R6-R10 are stored in child compression unit 610.

In both column major and row major situations, the map 726 may be a one or two byte vector with length equal to the number of contained units. In one example, each entry in the vector is the number of rows or columns in the corresponding child compression unit. Thus, if the column map has entries 2, 5 and 3, then the first unit contains the first two columns in the order specified previously in the header, and then the second unit contains the next five columns, and the third unit contains the next three columns. If there is one column per unit, then both the number of units and column mapping may be eliminated.

The contained unit information 730 concludes with pointers 728 to the headers of each of the contained compression units. According to one example, these pointers are relative to the start of the uncompressed unit. The pointers are relative to the start of the uncompressed unit because, in order to make use of the contained unit information 730, including the pointers 728, the compressed section of the compression unit would have already been uncompressed.

### OBTAINING TABULAR DATA STORED IN COMPRESSION UNITS

The recursive nature of compression units allows tabular data to be compressed at each of many levels. For example, within a bottom-level compression unit, data may be compressed using run-length encoding. That bottom-level compression unit may be a child of an intermediate-level compression unit that compresses the bottom-level compression unit (and everything else in its compressed section) using LZO compression. That intermediate-level compression unit may be a child of a top-level compression unit that compresses the intermediate-level compression unit (and everything else in its compressed section) using BZIP2 compression.

To obtain tabular data, the various compression operations have to be undone in reverse chronological order. In the example given above, the data must be decompressed using BZIP2 decompression, then decompressed using LZO decompression, and then uncompressed using run-length decoding. Because each decompression operation consumes resources, it is desirable to only perform the decompression operations necessary for any particular operation.

For example, assume that a request is made for the names associated with rows R1 to R10 of table 300. As illustrated in FIG. 5, those names are in column B, which is stored in child compression unit 410. Thus, to obtain the names, the compressed section 204 would be decompressed. Once decompressed, the contained unit information within compressed section 204 can be read to determine that column B is stored in compression unit 410. The pointer to compression unit 410 is follow to find the header for compression unit 410. The header, which is stored in uncompressed section 412, contains metadata that indicates how compressed section 414 was compressed. Compressed section 414 may then be uncompressed to obtain the names.

Significantly, during the process of obtaining the names from column B, the compressed section 404 of compression unit 400 was not uncompressed, because compressed section 404 did not have any data or metadata necessary to obtain the names from rows R1 to R10. Conversely, if the request was for images and not names, compressed section 404 of compression unit 400 would have to be decompressed, while compressed section 414 of compression unit 410 would not be decompressed.

### DELETING TABULAR DATA STORED IN COMPRESSION UNITS

According to one example, tabular data is deleted, inserted and updated directly into compression units, in response to operations performed on the corresponding table. However, by performing such operations on the data itself, overhead is incurred due to the need to decompress the data before making the change, and then recompress the data after making the change.

In one example, the delete vector in delete vector field 718 (illustrated in FIG. 7) is used to delete rows from a table without actually deleting, from the compression unit, the data that the rows contain. For example, assume that a particular compression unit stores data for 1000 rows. The corresponding delete vector may include 1000 bits, where the position of the bit indicates the row to which the bit corresponds. If a request is received to delete the 10th row from the compression unit, then the 10th bit of the delete vector is set to indicate that the corresponding row is deleted. However, the actual data for the 10th row is not actually deleted from the compressed section of the compression unit.

Various benefits result from treating deletions in this manner. For example, by using the delete vector, deletions do not incur the overhead associated with decompressing the compressed section of a compression unit (and any lower-level compression units contained therein), because the delete vector is in the uncompressed section of the compression unit.

Further, the decompression overhead is not the only overhead avoided by using the delete vector. Specifically, if the compressed section was decompressed to remove the deleted row, then the compressed section would have to be recompressed after the row data was removed, thereby incurring more overhead. In addition, deletion of data from a compressed set of data may, under some circumstances, actually increase the compressed size of the data.

In one example, rather than include a delete vector in the header of all compression units, the delete vector is only included at the top-level compression units. Inspection of the top-level delete vector indicates which rows have been deleted without having to access the headers of any lower-level compression units.

According to one example, if the number of rows that are deleted exceeds a particular threshold, then the entire compression unit is rewritten. For example, if the bit vector indicates that more than half of the rows within a compression unit have been deleted, the compression unit may be decompressed, and the not-yet-deleted rows may be recompressed and stored in a new compression unit. During this process, the data from many compression units may be combined into a new, smaller set of compression units.

### INSERTING TABULAR DATA

The addition of data into a compression unit could incur significant overhead penalties, due to the decompression and recompression that would be required. Further, the resulting compression unit may be larger than desired. Therefore, according to one example, newly added tabular data is not inserted into existing compression units. Instead, the newly added tabular data is either stored in a separate format, or stored in newly formed compression units. For example, if a single row is being inserted into table 300, the row may be stored external to compression unit 200. The row may be stored in conventional row-major disk blocks, or a row-based compression technique. When some tabular data for a table is stored in compression units, and other tabular data for the same table is stored external to compression units, the location of the data that is stored external to compression units is referred to herein as the "overflow area".

In one example, when the amount of data to be inserted into table 300 exceeds a threshold, then the data is not stored in the overflow area. Rather, the new data is stored in new compression units. For example, if a bulk load operation is performed to add thousands of rows to table 300, then one or more new compression units may be created to store the tabular data for the new rows. According to one example, the new top-level compression units would automatically inherit the same internal structure as compression unit 200, including the structure and organization of the compression units that descend from compression unit 200.

In one example, in response to the data in the overflow area for table 300 exceeding a particular threshold, the overflow data is automatically moved into one or more new compression units. For example, several smaller load operations may result in the overflow area having thousands of rows. In response to detecting that the size of the data in the overflow area has exceeded some threshold, the data from the overflow may be repackaged into one or more new compression units for table 300. Similar to the bulk load situation, the new top-level compression units that are created to store the data from the overflow area for table 300 may have the same internal structure as compression unit 200.

### UPDATING TABULAR DATA

According to one example, updates are treated as deletions combined with inserts. Thus, when a value is updated in a row of table 300, the delete vector in compression unit 200 is updated to indicate that the row is deleted, and a row with the updated values is stored in the overflow area.

Frequently, there will be some columns of an updated row that are not changed by an update operation. Consequently, prior to storing the updated row in the overflow area, the compressed section of the compression unit (and any child compression units) may have to be decompressed to recover the pre-update values of the row. The new row stored in the overflow area includes the pre-update values of the columns of the row that were not changed, and new values for the columns of the row that were changed.

### READING TABULAR DATA

In an example, that uses an overflow area, table scans must read both the data that is stored in the overflow area, and the data that is stored in compression units. Thus, a single table scan may involve combining data from several differently organized compression units, from compressed data in the overflow area, and from uncompressed data in the overflow area.

### HARDWARE OVERVIEW

According to one embodiment, the techniques described herein are implemented by one or more special-purpose computing devices. The special-purpose computing devices may be hard-wired to perform the techniques, or may include digital electronic devices such as one or more application-specific integrated circuits (ASICs) or field programmable gate arrays (FPGAs) that are persistently programmed to perform the techniques, or may include one or more general purpose hardware processors programmed to perform the techniques pursuant to program instructions in firmware, memory, other storage, or a combination. Such special-purpose computing devices may also combine custom hard-wired logic, ASICs, or FPGAs with custom programming to accomplish the techniques. The special-purpose computing devices may be desktop computer systems, portable computer systems, handheld devices, networking devices or any other device that incorporates hard-wired and/or program logic to implement the techniques.

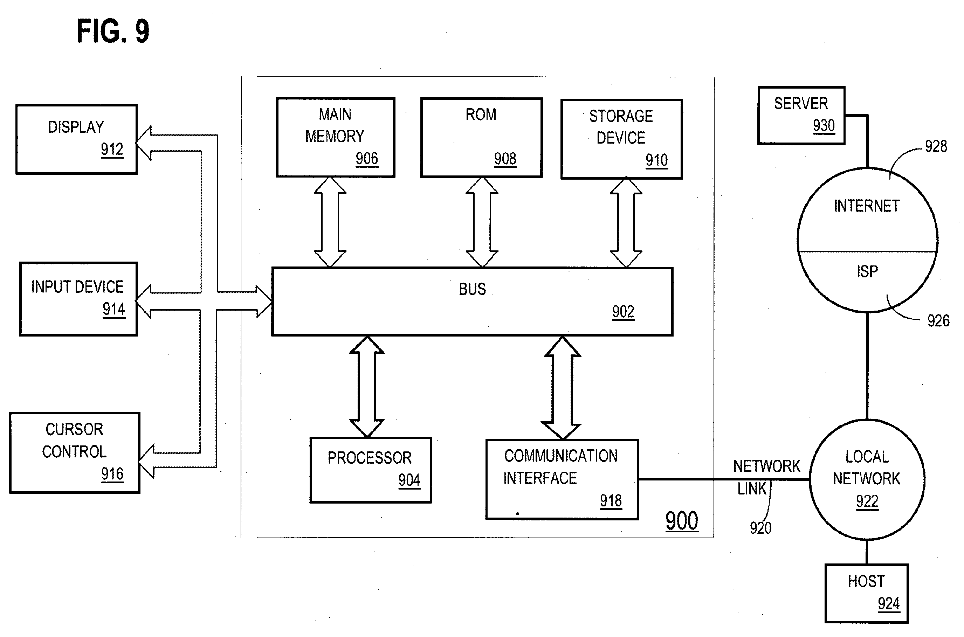

For example, FIG. 9 is a block diagram that illustrates a computer system 900 upon which an embodiment of the invention may be implemented. Computer system 900 includes a bus 902 or other communication mechanism for communicating information, and a hardware processor 904 coupled with bus 902 for processing information. Hardware processor 904 may be, for example, a general purpose microprocessor.

Computer system 900 also includes a main memory 906, such as a random access memory (RAM) or other dynamic storage device, coupled to bus 902 for storing information and instructions to be executed by processor 904. Main memory 906 also may be used for storing temporary variables or other intermediate information during execution of instructions to be executed by processor 904. Such instructions, when stored in storage media accessible to processor 904, render computer system 900 into a special-purpose machine that is customized to perform the operations specified in the instructions.

Computer system 900 further includes a read only memory (ROM) 908 or other static storage device coupled to bus 902 for storing static information and instructions for processor 904. A storage device 910, such as a magnetic disk or optical disk, is provided and coupled to bus 902 for storing information and instructions.

Computer system 900 may be coupled via bus 902 to a display 912, such as a cathode ray tube (CRT), for displaying information to a computer user. An input device 914, including alphanumeric and other keys, is coupled to bus 902 for communicating information and command selections to processor 904. Another type of user input device is cursor control 916, such as a mouse, a trackball, or cursor direction keys for communicating direction information and command selections to processor 904 and for controlling cursor movement on display 912. This input device typically has two degrees of freedom in two axes, a first axis (e.g., x) and a second axis (e.g., y), that allows the device to specify positions in a plane.

Computer system 900 may implement the techniques described herein using customized hard-wired logic, one or more ASICs or FPGAs, firmware and/or program logic which in combination with the computer system causes or programs computer system 900 to be a special-purpose machine. According to one embodiment, the techniques herein are performed by computer system 900 in response to processor 904 executing one or more sequences of one or more instructions contained in main memory 906. Such instructions may be read into main memory 906 from another storage medium, such as storage device 910. Execution of the sequences of instructions contained in main memory 906 causes processor 904 to perform the process steps described herein. In alternative embodiments, hard-wired circuitry may be used in place of or in combination with software instructions.

The term "storage media" as used herein refers to any media that store data and/or instructions that cause a machine to operation in a specific fashion. Such storage media may comprise non-volatile media and/or volatile media. Non-volatile media includes, for example, optical or magnetic disks, such as storage device 910. Volatile media includes dynamic memory, such as main memory 906. Common forms of storage media include, for example, a floppy disk, a flexible disk, hard disk, solid state drive, magnetic tape, or any other magnetic data storage medium, a CD-ROM, any other optical data storage medium, any physical medium with patterns of holes, a RAM, a PROM, and EPROM, a FLASH-EPROM, NVRAM, any other memory chip or cartridge.

Storage media is distinct from but may be used in conjunction with transmission media. Transmission media participates in transferring information between storage media. For example, transmission media includes coaxial cables, copper wire and fiber optics, including the wires that comprise bus 902. Transmission media can also take the form of acoustic or light waves, such as those generated during radio-wave and infra-red data communications.

Various forms of media may be involved in carrying one or more sequences of one or more instructions to processor 904 for execution. For example, the instructions may initially be carried on a magnetic disk or solid state drive of a remote computer. The remote computer can load the instructions into its dynamic memory and send the instructions over a telephone line using a modem. A modem local to computer system 900 can receive the data on the telephone line and use an infra-red transmitter to convert the data to an infra-red signal. An infra-red detector can receive the data carried in the infra-red signal and appropriate circuitry can place the data on bus 902. Bus 902 carries the data to main memory 906, from which processor 904 retrieves and executes the instructions. The instructions received by main memory 906 may optionally be stored on storage device 910 either before or after execution by processor 904.

Computer system 900 also includes a communication interface 918 coupled to bus 902. Communication interface 918 provides a two-way data communication coupling to a network link 920 that is connected to a local network 922. For example, communication interface 918 may be an integrated services digital network (ISDN) card, cable modem, satellite modem, or a modem to provide a data communication connection to a corresponding type of telephone line. As another example, communication interface 918 may be a local area network (LAN) card to provide a data communication connection to a compatible LAN. Wireless links may also be implemented. In any such implementation, communication interface 918 sends and receives electrical, electromagnetic or optical signals that carry digital data streams representing various types of information.

Network link 920 typically provides data communication through one or more networks to other data devices. For example, network link 920 may provide a connection through local network 922 to a host computer 924 or to data equipment operated by an Internet Service Provider (ISP) 926. ISP 926 in turn provides data communication services through the world wide packet data communication network now commonly referred to as the "Internet" 928. Local network 922 and Internet 928 both use electrical, electromagnetic or optical signals that carry digital data streams. The signals through the various networks and the signals on network link 920 and through communication interface 918, which carry the digital data to and from computer system 900, are example forms of transmission media.

Computer system 900 can send messages and receive data, including program code, through the network(s), network link 920 and communication interface 918. In the Internet example, a server 930 might transmit a requested code for an application program through Internet 928, ISP 926, local network 922 and communication interface 918.

The received code may be executed by processor 904 as it is received, and/or stored in storage device 910, or other non-volatile storage for later execution.

In the foregoing specification, embodiments of the invention have been described with reference to numerous specific details that may vary from implementation to implementation. The specification and drawings are, accordingly, to be regarded in an illustrative rather than a restrictive sense.

## Claims

1. A method performed by one or more computing devices, the method comprising:
loading each XML document of a plurality of XML documents into a table (300) in which said XML documents are stored in shredded form, wherein loading said each XML document comprises:
generating, from said XML document, a plurality of column values of a plurality of columns of the table (300), said plurality of column values to be stored in a plurality of rows in the table (300);
analyzing said plurality of column values;
for each column of said plurality of columns and those column values of the plurality of column values that are generated from said XML document for this column, making a determination of a row-storage format for storing said column values, said making a determination including:
determining whether to store said column values in column-major or row-major format, and
determining whether to use a compression technique to compress said column values; and
storing the column values according to said determinations of the row-storage format for said plurality of columns;
wherein said plurality of XML documents includes a first XML document and a second XML document;
wherein for said first XML document and for a particular column of said plurality of columns, said particular column comprising first particular column values generated from said first XML document, said making a determination of the row-storage format includes to store said first particular column values of said particular column in column-major format; and
wherein for said second XML document and for said particular column of said plurality of columns, said particular column comprising second particular column values generated from said second XML document, said making a determination of the row-storage format includes to store said second particular column values of said particular column in row-major format.

2. The method of claim 1, wherein:
said plurality of XML documents includes a third XML document; and
wherein for said particular column of said plurality of columns, said particular column comprising third particular column values generated from said third XML document, said making a determination of the row-storage format includes:
determining to store said third particular column values of said particular column in column-major format;
determining, for said first XML document, to use a first compression technique to store the first particular column values of said particular column; and
determining, for said third XML document, to use a second compression technique to store the third particular column values of said particular column;
wherein said first compression technique is different than said second compression technique.

3. The method of claim 1 or claim 2,
wherein a database server manages access to said table (300), wherein the steps further include storing said plurality of XML documents in a second table;
wherein said plurality of columns of said table (300) include:
a first column that stores node values of nodes in said plurality of XML documents, and
a second column that stores values that indicate a row in said second table that stores a XML document of said plurality of XML documents.

4. The method of claim 1 or claim 2, wherein said data for said table (300) is stored in compression units.

5. A computer system comprising:
means for loading each XML document of a plurality of XML documents into a table (300) in which said XML documents are stored in shredded form, wherein the means for loading said each XML document comprises:
means for generating, from said XML document, a plurality of column values of a plurality of columns of the table (300), said plurality of column values to be stored in a respective plurality of rows in the table (300);
means for analyzing said plurality of column values;
means for making, for each column of said plurality of columns and those column values of the plurality of column values that are generated from said XML document for this column, a determination of a row-storage format for storing said column values, the means for making a determination including:
means for determining whether to store said column values in column-major or row-major format, and
means for determining whether to use a compression technique to compress said column values; and
means for storing the plurality of column values according to said determinations of the row-storage format for said plurality of columns;
wherein said plurality of XML documents includes a first XML document and a second XML document;
wherein for said first XML document and for a particular column of said plurality of columns, said particular column comprising first particular column values generated from said first XML document, said making a determination of the row-storage format includes to store said first particular column values of said particular column in column-major format; and
wherein for said second XML document and for said particular column of said plurality of columns, said particular column comprising second particular column values generated from said second XML document, said making a determination of the row-storage format includes to store said second particular column values of said particular column in row-major format.

6. The computer system of claim 5, wherein the computer system is adapted for performing the steps recited in any of claims 1-4.

7. A computer program product storing instructions which, when executed, cause one or more processors (904) to perform the steps recited in any of claims 1-4.

## Patentansprüche

1. Verfahren, das von einer oder mehreren Rechenvorrichtungen ausgeführt wird, wobei das Verfahren umfasst:
Laden jedes XML-Dokuments einer Mehrzahl von XML-Dokumenten in eine Tabelle (300), in der die XML-Dokumente in Schnipselform gespeichert sind, wobei das Laden jedes solchen XML-Dokuments umfasst:
Erzeugen einer Mehrzahl von Spaltenwerten einer Mehrzahl von Spalten der Tabelle (300) aus dem XML-Dokument, wobei die Mehrzahl von Spaltenwerten in einer Mehrzahl von Zeilen der Tabelle (300) gespeichert werden soll;
Analysieren der Mehrzahl von Spaltenwerten;
für jede Spalte der Mehrzahl von Spalten und diejenigen Spaltenwerte der Mehrzahl von Spaltenwerten, die für diese Spalte aus dem XML-Dokument erzeugt worden sind, wird eine Bestimmung eines Zeilenspeicherformats zum Speichern dieser Spaltenwerte durchgeführt, wobei das Durchführen einer Bestimmung umfasst:
Bestimmen, ob die Spaltenwerte in einem spaltenweisen Format oder einem zeilenweisen Format gespeichert werden sollen, und
Bestimmen, ob ein Kompressionsverfahren zum Komprimieren der Spaltenwerte verwendet werden soll; und
Speichern der Spaltenwerte gemäß den Bestimmungen des Zeilenspeicherformats für die Mehrzahl von Spalten;
wobei die Mehrzahl von XML-Dokumenten ein erstes XML-Dokument und ein zweites XML-Dokument umfasst;
wobei, für das erste XML-Dokument und für eine bestimmte Spalte der Mehrzahl von Spalten, wobei die bestimmte Spalte erste bestimmte Spaltenwerte aufweist, die aus dem ersten XML-Dokument erzeugt worden sind, das Durchführen einer Bestimmung des Zeilenspeicherformats umfasst, dass die ersten bestimmten Spaltenwerte der bestimmten Spalte im spaltenweisen Format gespeichert werden; und
wobei, für das zweite XML-Dokument und für die bestimmte Spalte der Mehrzahl von Spalten, wobei die bestimmte Spalte zweite bestimmte Spaltenwerte umfasst, die aus dem zweiten XML-Dokument erzeugt worden sind, das Durchführen einer Bestimmung des Zeilenspeicherformats umfasst, dass die zweiten bestimmten Spaltenwerte der bestimmten Spalte im zeilenweisen Format gespeichert werden.

2. Verfahren nach Anspruch 1, bei dem:
die Mehrzahl von XML-Dokumenten ein drittes XML-Dokument umfasst; und
wobei für die bestimmte Spalte der Mehrzahl von Spalten, wobei die bestimmte Spalte dritte bestimmte Spaltenwerte umfasst, die aus dem dritten XML-Dokument erzeugt worden sind, das Durchführen einer Bestimmung des Zeilenspeicherformats umfasst:
Bestimmen, dass die dritten bestimmten Spaltenwerte der bestimmten Spalte im spaltenweisen Format gespeichert werden;
Bestimmen, dass für das erste XML-Dokument ein erstes Kompressionsverfahren verwendet wird, um die ersten bestimmten Spaltenwerte der bestimmten Spalte zu speichern; und
Bestimmen, dass für das dritte XML-Dokument ein zweites Kompressionsverfahren verwendet wird, um die dritten bestimmten Spaltenwerte der bestimmten Spalte zu speichern;
wobei sich das erste Kompressionsverfahren von dem zweiten Kompressionsverfahren unterscheidet.

3. Verfahren nach Anspruch 1 oder Anspruch 2,
bei dem ein Datenbankserver den Zugriff auf die Tabelle (300) verwaltet, wobei die Schritte ferner umfassen, dass die Mehrzahl von XML-Dokumenten in einer zweiten Tabelle gespeichert wird;
wobei die Mehrzahl von Spalten der Tabelle (300) umfasst:
eine erste Spalte, die Knotenwerte von Knoten in der Mehrzahl von XML-Dokumenten speichert, und
eine zweite Spalte, die Werte speichert, welche eine Zeile in der zweiten Tabelle angeben, die ein XML-Dokument der Mehrzahl von XML-Dokumenten speichert.

4. Verfahren nach Anspruch 1 oder Anspruch 2, bei dem die Daten für die Tabelle (300) in Kompressionseinheiten gespeichert werden.

5. Computersystem, das aufweist:
Mittel zum Laden jedes XML-Dokuments einer Mehrzahl von XML-Dokumenten in eine Tabelle (300), in der die XML-Dokumente in Schnipselform gespeichert sind, wobei die Mittel zum Laden jedes solchen XML-Dokuments aufweisen:
Mittel zum Erzeugen einer Mehrzahl von Spaltenwerten einer Mehrzahl von Spalten der Tabelle (300) aus dem XML-Dokument, wobei die Mehrzahl von Spaltenwerten in einer Mehrzahl von Zeilen der Tabelle (300) gespeichert werden soll;
Mittel zum Analysieren der Mehrzahl von Spaltenwerten;
Mittel zum Durchführen, für jede Spalte der Mehrzahl von Spalten und diejenigen Spaltenwerte der Mehrzahl von Spaltenwerten, die für diese Spalte aus dem XML-Dokument erzeugt worden sind, einer Bestimmung eines Zeilenspeicherformats zum Speichern dieser Spaltenwerte, wobei die Mittel zum Durchführen einer Bestimmung aufweisen:
Mittel zum Bestimmen, ob die Spaltenwerte in einem spaltenweisen Format oder einem zeilenweisen Format gespeichert werden sollen, und
Mittel zum Bestimmen, ob ein Kompressionsverfahren zum Komprimieren der Spaltenwerte verwendet werden soll; und
Mittel zum Speichern der Mehrzahl von Spaltenwerten gemäß den Bestimmungen des Zeilenspeicherformats für die Mehrzahl von Spalten;
wobei die Mehrzahl von XML-Dokumenten ein erstes XML-Dokument und ein zweites XML-Dokument umfasst;
wobei, für das erste XML-Dokument und für eine bestimmte Spalte der Mehrzahl von Spalten, wobei die bestimmte Spalte erste bestimmte Spaltenwerte aufweist, die aus dem ersten XML-Dokument erzeugt worden sind, das Durchführen einer Bestimmung des Zeilenspeicherformats umfasst, dass die ersten bestimmten Spaltenwerte der bestimmten Spalte im spaltenweisen Format gespeichert werden; und
wobei, für das zweite XML-Dokument und für die bestimmte Spalte der Mehrzahl von Spalten, wobei die bestimmte Spalte zweite bestimmte Spaltenwerte umfasst, die aus dem zweiten XML-Dokument erzeugt worden sind, das Durchführen einer Bestimmung des Zeilenspeicherformats umfasst, dass die zweiten bestimmten Spaltenwerte der bestimmten Spalte im zeilenweisen Format gespeichert werden.

6. Computersystem nach Anspruch 5, wobei das Computersystem dazu eingerichtet ist, die in einem der Ansprüche 1-4 genannten Schritte auszuführen.

7. Computerprogrammprodukt, das Programmbefehle speichert, die, wenn sie ausgeführt werden, einen oder mehrere Prozessoren (904) dazu veranlassen, die in einem der Ansprüche 1-4 genannten Schritte auszuführen.

## Revendications

1. Un procédé exécutée par un ou plusieurs dispositifs informatiques, le procédé comprenant :
le chargement de chaque document XML d'une pluralité de documents XML dans une table (300) dans laquelle lesdits documents XML sont conservées en mémoire sous forme décomposée, où le chargement dudit chaque document XML comprend :
la génération, à partir dudit document XML, d'une pluralité de valeurs de colonne d'une pluralité de colonnes de la table (300), ladite pluralité de valeurs de colonne étant destinées à être conservées en mémoire dans une pluralité de lignes de la table (300),
l'analyse de ladite pluralité de valeurs de colonne,
pour chaque colonne de ladite pluralité de colonnes et lesdites valeurs de colonne de la pluralité de valeurs de colonne qui sont générées à partir dudit document XML pour cette colonne, la détermination d'un format de conservation en lignes pour la conservation en mémoire desdites valeurs de colonne, ladite détermination comprenant :
la détermination s'il convient de conserver en mémoire lesdites valeurs de colonne dans un format majoritairement en colonnes ou un format majoritairement en lignes, et
la détermination s'il convient d'utiliser une technique de compression pour la compression desdites valeurs de colonne, et
la conservation en mémoire des valeurs de colonne selon lesdites déterminations du format de conservation en lignes pour ladite pluralité de colonnes,
où ladite pluralité de documents XML comprend un premier document XML et un deuxième document XML,
où pour ledit premier document XML et pour une colonne particulière de ladite pluralité de colonnes, ladite colonne particulière comprenant des premières valeurs de colonne particulières générées à partir dudit premier document XML, ladite détermination du format de conservation en lignes comprend la conservation en mémoire desdites premières valeurs de colonne particulières de ladite colonne particulière dans un format majoritairement en colonnes, et
où pour ledit deuxième document XML et pour ladite colonne particulière de ladite pluralité de colonnes, ladite colonne particulière comprenant des deuxièmes valeurs de colonne particulières générées à partir dudit deuxième document XML, ladite détermination du format de conservation en lignes comprend la conservation en mémoire desdites deuxièmes valeurs de colonne particulières de ladite colonne particulière dans un format majoritairement en lignes.

2. Le procédé selon la Revendication 1, où :
ladite pluralité de documents XML comprend un troisième document XML, et
où pour ladite colonne particulière de ladite pluralité de colonnes, ladite colonne particulière comprenant des troisièmes valeurs de colonne particulières générées à partir dudit troisième document XML, ladite détermination du format de conservation en lignes comprend :
la détermination de conservation en mémoire desdites troisièmes valeurs de colonne particulières de ladite colonne particulière dans un format majoritairement en colonnes,
la détermination, pour ledit premier document XML, d'utiliser une première technique de compression de façon à conserver en mémoire les premières valeurs de colonne particulières de ladite colonne particulière, et
la détermination, pour ledit troisième document XML, d'utiliser une deuxième technique de compression de façon à conserver en mémoire les troisièmes valeurs de colonne particulières de ladite colonne particulière,
où ladite première technique de compression est différente de ladite deuxième technique de compression.

3. Le procédé selon la Revendication 1 ou 2,
où un serveur de base de données gère l'accès à ladite table (300), où les opérations comprennent en outre la conservation en mémoire de ladite pluralité de documents XML dans une deuxième table,
où ladite pluralité de colonnes de ladite table (300) comprend :
une première colonne qui conserve en mémoire des valeurs de noeud de noeud dans ladite pluralité de documents XML, et
une deuxième colonne qui conserve en mémoire des valeurs qui indiquent une ligne dans ladite deuxième table qui conserve en mémoire un document XML de ladite pluralité de documents XML.

4. Le procédé selon la Revendication 1 ou 2, où lesdites données pour ladite table (300) sont conservées en mémoire dans des unités de compression.

5. Un système informatique comprenant :
un moyen de chargement de chaque document XML d'une pluralité de documents XML dans une table (300) dans laquelle lesdits documents XML sont conservés en mémoire sous forme décomposée, où le moyen du chargement dudit chaque document XML comprend :
un moyen de génération, à partir dudit document XML, d'une pluralité de valeurs de colonne d'une pluralité de colonnes de la table (300), ladite pluralité de valeurs de colonne étant destinées à être conservées en mémoire dans une pluralité respective de lignes dans la table (300),
un moyen d'analyse de ladite pluralité de valeurs de colonne,
un moyen de détermination, pour chaque colonne de ladite pluralité de colonnes et lesdites valeurs de colonne de la pluralité de valeurs de colonne qui sont générées à partir dudit document XML pour cette colonne, d'un format de conservation en lignes pour la conservation en mémoire desdites valeurs de colonne, le moyen de détermination comprenant :
un moyen de détermination s'il convient de conserver en mémoire lesdites valeurs de colonne dans un format majoritairement en colonnes ou un format majoritairement en lignes, et
un moyen de détermination s'il convient d'utiliser une technique de compression pour la compression desdites valeurs de colonne, et
un moyen de conservation en mémoire de la pluralité de valeurs de colonne selon lesdites déterminations du format de conservation en lignes pour ladite pluralité de colonnes,
où ladite pluralité de documents XML comprend un premier document XML et un deuxième document XML,
où pour ledit premier document XML et pour une colonne particulière de ladite pluralité de colonnes, ladite colonne particulière comprenant des premières valeurs de colonne particulières générées à partir dudit premier document XML, ladite détermination du format de conservation en lignes comprend la conservation en mémoire desdites premières valeurs de colonne particulières de ladite colonne particulière dans un format majoritairement en colonnes, et
où pour ledit deuxième document XML et pour ladite colonne particulière de ladite pluralité de colonnes, ladite colonne particulière comprenant des deuxièmes valeurs de colonne particulières générées à partir dudit deuxième document XML, ladite détermination du format de conservation en lignes comprend la conservation en mémoire desdites deuxièmes valeurs de colonne particulières de ladite colonne particulière dans un format majoritairement en lignes.

6. Le système informatique selon la Revendication 5, où le système informatique est adapté de façon à exécuter les opérations décrites dans l'une quelconque des Revendications 1 à 4.

7. Un produit de programme informatique contenant en mémoire des instructions qui, lorsqu'elles sont exécutés, amènent un ou plusieurs processeurs (904) à exécuter les opérations décrites dans l'une quelconque des Revendications 1 à 4.
